# EUROPEAN PATENT APPLICATION

(11) **EP 4 687 235 A1**
(43) Date of publication of application: **04.02.2026**
(21) Application number: 24191605.5
(22) Date of filing: 29.07.2024
(51) Int. Cl.: H01S 5/12, H01S 5/187

(54) **SURFACE EMITTING LASING DEVICE**

(71) Applicant: Imec VZW, 3001 Leuven (BE); Universiteit Gent, 9000 Gent (BE)
(72) Inventor: VAN THOURHOUT, Dries, 9040 Sint-Amandsberg (BE); FAHMY, Eslam, 9000 Gent (BE); COLUCCI, Davide, 1000 Brussel (BE); KUNERT, Bernardette, 4851 Gemmenich (BE)
(74) Representative: Winger

(57) **Abstract**

A surface emitting lasing device (100) is described comprising a substrate (110) and an array (120) of parallel nano-ridge devices (120a, 120b, 120c, ...) epitaxially grown on the substrate (110). The nano-ridge devices (120a, 120b, 120c, ...) are configured for together forming a laser cavity supporting a slow light band-edge lasing mode for lasing across the array of parallel nano-ridge devices (120a, 120b, 120c, ...) and being configured for coupling out said laser mode from the surface of the substrate (110) to enable surface emission.

## Description

### Field of the Invention

The present invention relates to the field of surface emitting lasing devices, and more specifically to a surface emitting lasing device comprising an array of parallel nano-ridge devices configured to form a laser cavity supporting lasing across the array of nano-ridge devices, corresponding systems including such surface emitting lasing devices, and systems and methods of creating surface emission based thereon.

### Background of the Invention

Vertical-cavity surface-emitting lasers (VCSELs) are widely used in various applications such as data communication, consumer electronics, and sensing. These compact lasers offer advantages such as wafer-scale fabrication, low cost, and high efficiency. However, VCSELs face several challenges that limit their performance and applicability.

One major issue with VCSELs is the complex epitaxial growth process required to fabricate the device structure. VCSELs consist of a vertical stack of layers, including bottom and top distributed Bragg reflector (DBR) mirrors and a gain section. The DBR mirrors typically comprise 10-60 different layers that must be grown with high precision, which is a time-consuming and challenging task. This complex growth process also limits the range of wavelengths that can be easily achieved with VCSELs. Most commercial VCSELs operate at 850 nm or 980 nm, where efficient DBR mirrors can be grown relatively easily. Extending VCSELs to other important wavelengths, such as 1300 nm, 1550 nm, or mid-infrared, is extremely difficult due to the lack of suitable mirror materials.

Another limitation of VCSELs is the lack of wavelength tunability. The emission wavelength of a VCSEL is determined by the cavity design and cannot be varied across a wafer in a controlled manner. This hinders the development of multi-wavelength VCSEL arrays for wavelength-division multiplexing or sensing applications. Furthermore, monolithic integration of VCSELs with other photonic or electronic devices is challenging and rarely implemented, which restricts their use in integrated photonic systems.

Single-mode VCSELs, which are desirable for many applications, also face limitations in terms of output power and beam quality. The small aperture size required for single-mode operation limits the maximum output power and results in a highly divergent output beam. Increasing the power and beam quality of single-mode VCSELs remains a significant challenge.

Despite the widespread adoption and continuous improvements in VCSEL technology, there is still a need for novel surface-emitting laser architectures that can overcome the limitations of traditional VCSELs. New approaches are required to simplify the fabrication process, extend the wavelength coverage, enable wavelength tunability, facilitate monolithic integration, and improve the performance of single-mode devices. Advances in these areas will greatly expand the application space of surface-emitting lasers and enable new functionalities in optical communication, sensing, and other fields.

Nano-ridge engineering (NRE) which includes aspect ratio trapping (ART) of defects allows the growth of high-quality defect free active materials directly on silicon substrates without the need for a thick strain relaxation buffer layer. Previously, optically pumped DFB lasers and PIN-detectors were realized based on this technology, as described for example in Shi et al., "Loss-coupled DFB nano-ridge laser monolithically grown on a standard 300-mm Si wafer", Opt. Express 29, (2021) 14649-14657. Room-temperature electrically injected continuous-wave lasers are also known, leveraging mode beating between the fundamental cavity mode and a higher order mode to mitigate losses linked to the electrical contacts.

### Summary of the Invention

It is an object of embodiments of the present invention to provide surface emitting lasing devices with reduced growth complexity compared to VCSELs. This objective is accomplished by a device, system and methods as set out in the independent claims.

In the first aspect, the present invention relates to a surface emitting lasing device comprising:
- a substrate, and
- an array of parallel nano-ridge devices epitaxially grown on the substrate, the parallel nano-ridge devices being configured for together forming a laser cavity supporting a slow light band-edge lasing mode for lasing across the array of parallel nano-ridge devices and being configured for coupling out said laser mode from a surface of the substrate to enable surface emission. Whereas such emission typically may be emission via the top surface, emission through the bottom surface, through the substrate, alternatively or in addition may be performed in some embodiments, e.g. for those wavelengths for which the substrate, e.g. silicon substrate, is optically transparent.

This allows for lasing devices with reduced growth time and material consumption compared to VCSELs. The high index contrast in the grating results in good laser operation. Such devices can be used in sensing, spectroscopy, communication or other electronics or photonics applications.

In embodiments, the parallel nano-ridge devices may be arranged in a periodic array. This enables tuning the emission wavelength by selecting the array period, nano-ridge dimensions, or depositing additional materials.

In embodiments, the properties or the configuration of some of the nano-ridge devices and/or the properties of regions between some nano-ridge devices may differ from others in the array, inducing optical elements that influence the lasing mode. These optical elements may comprise an optical reflector.

In embodiments, additional material may be deposited between sub-sets of nano-ridge devices to induce reflection at boundaries across the array. Alternatively or in addition thereto, changing the period between sub-sets of nano-ridge devices and/or depositing an additional layer also may induce reflection. This allows reducing in-plane cavity losses by forming mirrors at the array sides, e.g. by locally shifting the photonic bandgap. Low index materials like silicon oxide can be used. Altering sub-sets at the edges and/or away from the edges enables in-plane confinement of the slow band-edge mode with high Q-factor, lowering the lasing threshold and/or obtain small devices.

In embodiments, periodicity may be introduced along the nano-ridge length direction through local material deposition in between, above or both in between and above parallel nano-ridge devices, forming a 2D photonic crystal nano-ridge laser.

In embodiments, the substrate may function as a bottom contact with top metal contacts added on nano-ridge devices for electrical injection. The device can be optically or electrically pumped.

In embodiments, the substrate may provide a crystalline surface for epitaxial growth. Examples of such substrates are silicon substrates, Ge substrates, engineered substrates such as SOI, GOI, InPoSi (InP on Silicon), III-V substrates such as GaAs, InP, InAs, GaSb, or reconstructed substrates. This enables very large-scale integration and high-volume production, as well as integration with other electronics/photonics.

In embodiments, the nano-ridge devices may be composed of III-V, II-VI, or group IV semiconductors. They may be configured to emit light in the 400-4000nm range, e.g. 400-3500nm or 400-2500nm.

In the second aspect, the invention relates to an integrated circuit comprising at least one surface emitting lasing device according to embodiments of the first aspect. This allows monolithic integration with other photonic or electronic devices.

In embodiments, the integrated circuit may comprise multiple surface emitting lasing devices on a common substrate, each configured for a specific laser mode or wavelength. Tuning the emission by the array period, nano-ridge dimensions, or additional materials enables multi-wavelength arrays on the same die/wafer. Changing the material composition allows addressing different wavelength ranges, with multiple growths enabling widely varying wavelengths on the same substrate.

In the third aspect, the invention relates to a method of manufacturing a surface emitting lasing device, comprising:
- providing a substrate, and
- epitaxially growing an array of parallel nano-ridge devices on the substrate, the array being configured to form together a laser cavity supporting a slow light band-edge mode for lasing across the array and coupling out the laser mode from the substrate surface to enable surface emission.

It is an advantage of embodiments of the present invention that lasing devices can be made with a reduced growth time and material consumption compared to VCSELs.

It is an advantage of embodiments of the present invention that a high index contrast is obtained in the grating, resulting in good laser operation.

It is an advantage of embodiments of the present invention that such lasing devices can be used in sensing, spectroscopy, communication or other electronics or photonics applications. It is an advantage of embodiments of the present invention that small lasing devices can be obtained.

It is an advantage of embodiments of the present invention that it allows for very large-scale integration and allows very high-volume production.

It is an advantage of embodiments of the present invention that integration with other electronics/photonics is easily possible.

It is an advantage of embodiments of the present invention that it allows for monolithic integration of a surface emitting lasing device with other photonic or electronic devices.

It is an advantage that different wavelength ranges are addressable, by changing the material composition.

It is an advantage that multiple growths with differing materials would even allow widely varying wavelengths on the same substrate.

It is an advantage of embodiments of the present invention and nano-ridge based surface emitting lasers (NRSEL) resulting therefrom that they offer reduced growth time compared to VCSELs attributed to the absence of complex DBR epitaxy and layers.

It is an advantage of at least some embodiments of the present invention and nano-ridge based surface emitting lasers (NRSEL) resulting therefrom that the emission wavelength can be tuned by changing the period of the array, the dimensions of the nano-ridges, or in post-processing by depositing additional materials (e.g. Silicon oxide, AlOx, or HfOx).

It is an advantage of at least some embodiments of the present invention and nano-ridge based surface emitting lasers (NRSEL) resulting therefrom that the utilization of arrays with slightly varied periods makes it possible to create multi-wavelength laser arrays on a single die or wafer, while variations in material composition enable targeting of different wavelength ranges.

It is an advantage of at least some embodiments of the present invention and nano-ridge based surface emitting lasers (NRSEL) resulting therefrom that the high index contrast of the grating promotes increased mode separation, ensuring the dominance of a single mode within the gain bandwidth and thereby ensuring single mode operation without any competing modes.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

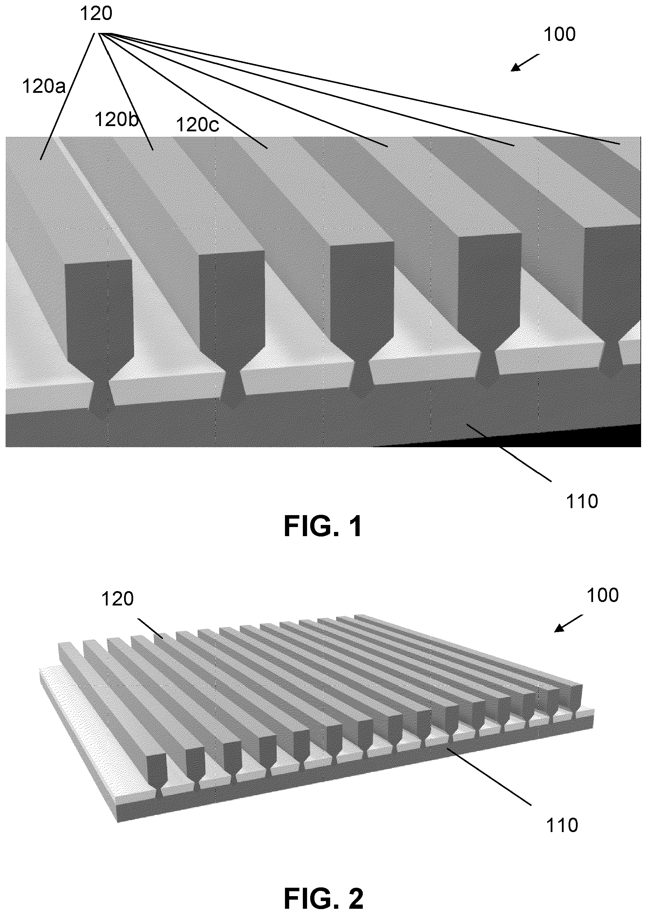

Fig. 1 is a schematic view of a surface emitting lasing device according to embodiments of the present invention.
Fig. 2 is a schematic view of a nano-ridge array of a surface emitting lasing device according to embodiments of the present invention.

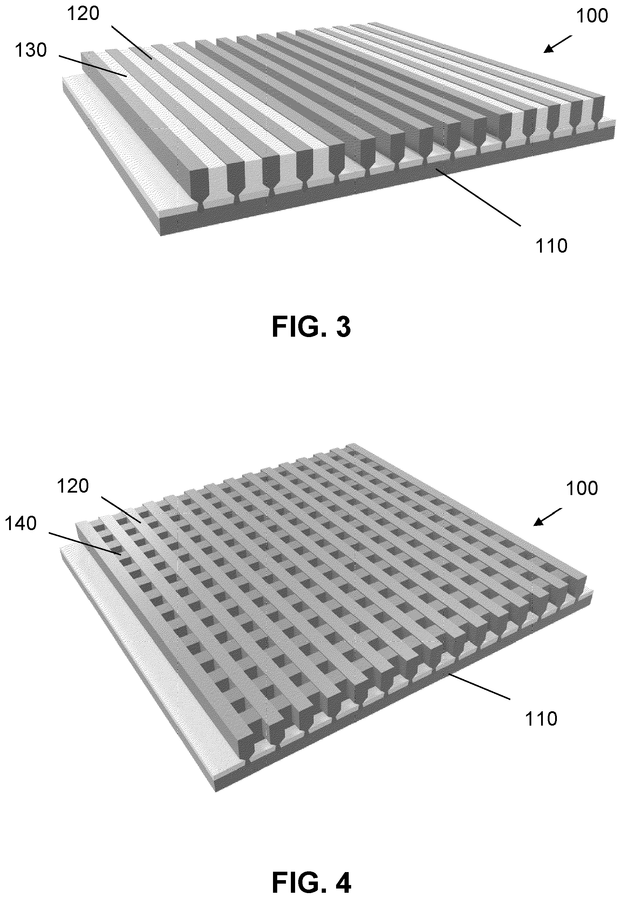

Fig. 3 is a schematic view of a nano-ridge array with additional material deposited between some nano-ridges to introduce optical features in the surface emitting lasing device according to embodiments of the present invention.

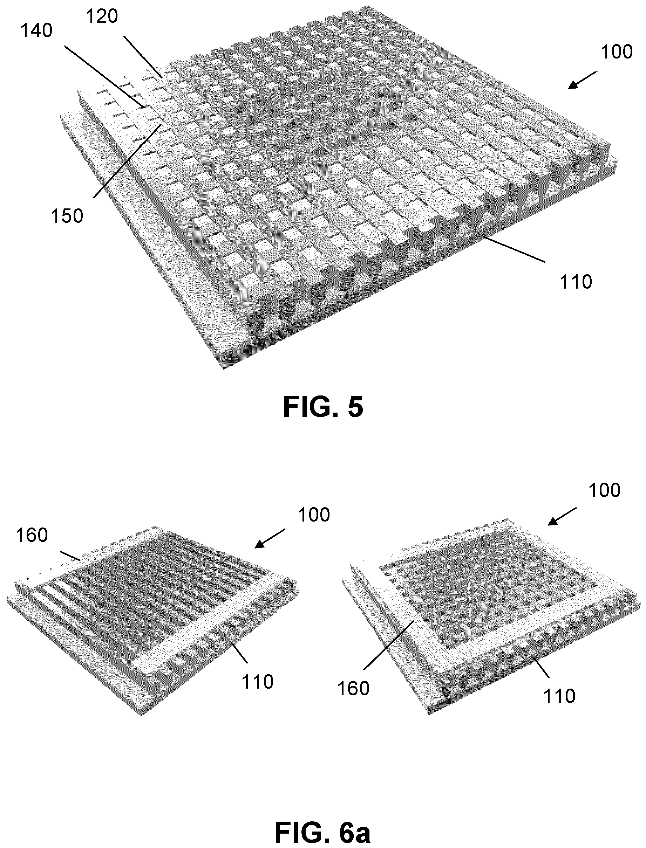

Fig. 4 and 5 are schematic views of two-dimensional nano-ridge photonic crystals with differently periodic characteristics through local deposited materials for a surface emitting lasing device according to embodiments of the present invention.

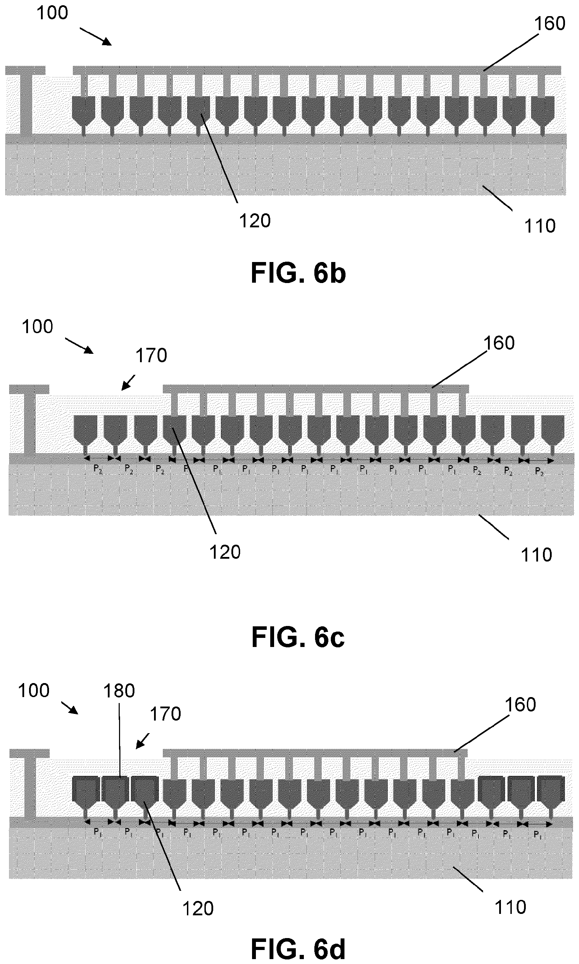

Fig. 6a to FIG. 6d are a schematic view of (FIG. 6a) an electrically injected one dimensional nano-ridge array laser of a surface emitting lasing device (left) and of an electrically injected two-dimensional nano-ridge laser of a surface emitting lasing device (right) according to embodiments of the present invention, and (FIG. 6b, FIG. 6c and FIG. 6d) schematic views of further configurations of electrically injected surface emitting lasing devices.

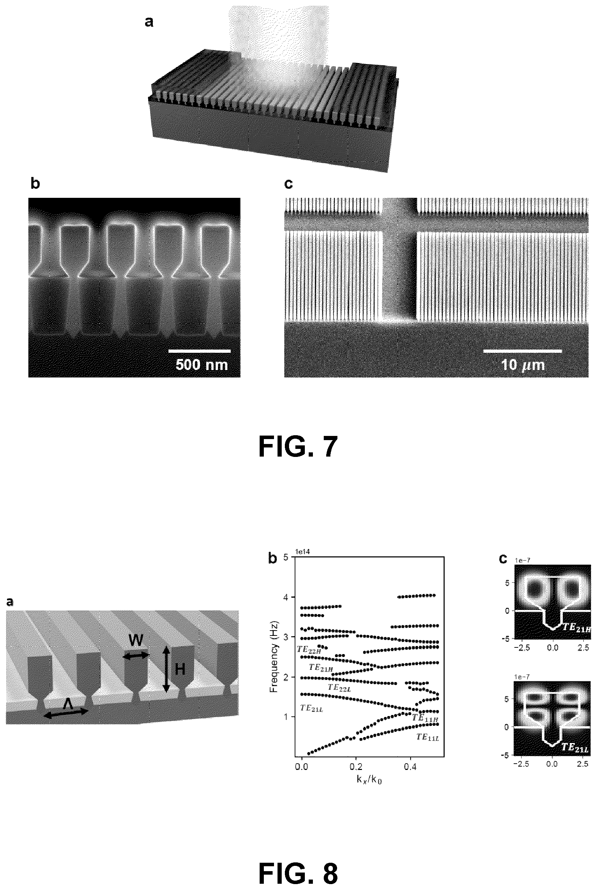

FIG. 7 is an illustration of a nano-ridge surface emitting device (a), a SEM image of a cross-section of a cleaved array of nano-ridges (b) and a top view SEM image of arrays of nano-ridges on a Si wafer (c), according to an exemplary embodiment of the present invention.
FIG. 8 illustrates an array of nano-ridges according to an exemplary embodiment of the present invention, (a) with the important design dimensional parameters, whereby a 2D FDTD simulation of the dispersion diagram (b) for an array of nano-ridges with different modes that can be supported inside the structure is shown as well as the mode profiles (c) for the first two band edge modes at the Γ point (kₓ/k₀=0).

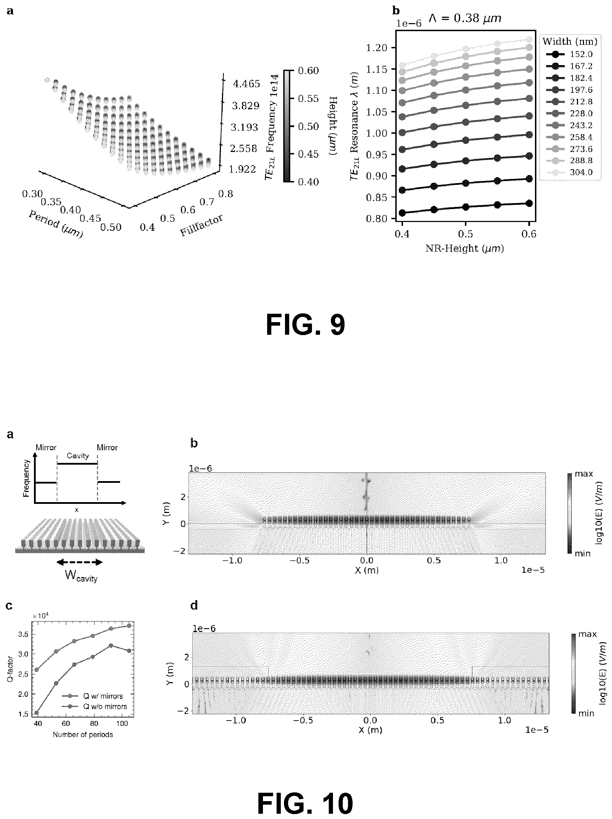

FIG. 9 illustrates, for the example of FIG. 8, the TE_{21L} mode's resonance frequency sweep for different periods, nano-ridge widths, and heights obtained from FDTD dispersion diagram calculations, wherein part (a) shows the resonance frequency is significantly affected by the period (Λ) of the nano-ridge array, followed by the nano-ridge width (Fillfactor) (the height of the nano-ridge (H) has the least effect on the resonance frequency). Part (b) shows the resonance wavelength (λ) plotted for the chosen design period Λ = 0.38 µm, indicating the significant effect of the nano-ridge width on the optical mode's TE_{21L} resonance frequency especially at shorter wavelengths.
FIG. 10 illustrates, for the example of FIG. 8, (a) side mirrors shift the slow Bloch to longer wavelength, forming a barrier around the middle cavity, enhancing the electric field in the cavity, and reducing the lateral losses; (b) a 2D FDTD simulation of finite nano-ridge crystal, showing a cross-section of the SBM TE_{21L} without side mirrors; (c) calculated Q-factor with and without side mirrors for different number of periods and (d) the mode profile showing the electric field confined in the middle of the cavity and reflection at the boundaries with the deposited SiO₂.

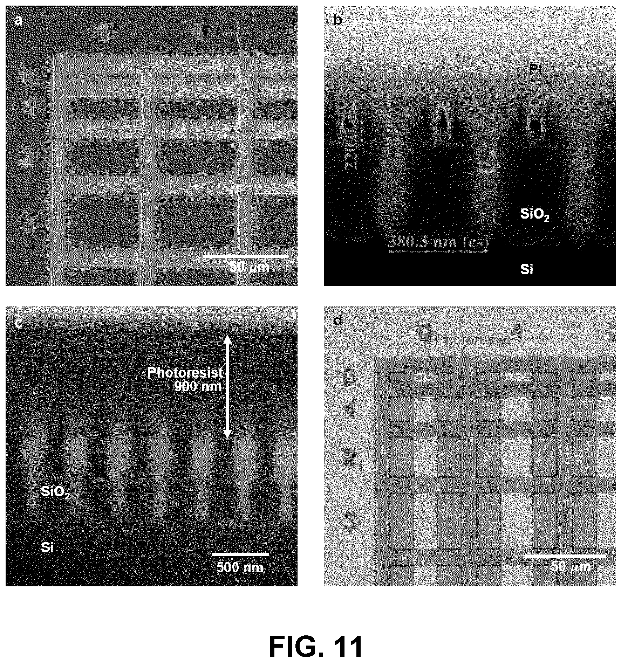

FIG. 11 illustrates fabrication processes for devices according to embodiments of the present invention, wherein part (a) shows an XSEM image showing the definition of NRSEL array after the successful etching of the nano-ridge material using ICP (pointing arrow); part (b) shows a FIB (focused ion beam) image indicating the successful removal of the III-V materials especially the quantum wells, whereby the nano-ridge height before etching was 410 nm and after the etching only parts of the side InGaP capping layer are left. Part (c) shows a FIB (focused ion beam) image after the spin coating of the side photoresist (PR) mirrors, indicating a successful coverage with a height of 900 nm on top of the nano-ridges and part (d) shows an optical image of the NRs after NRSEL definition and the development of the side mirrors.

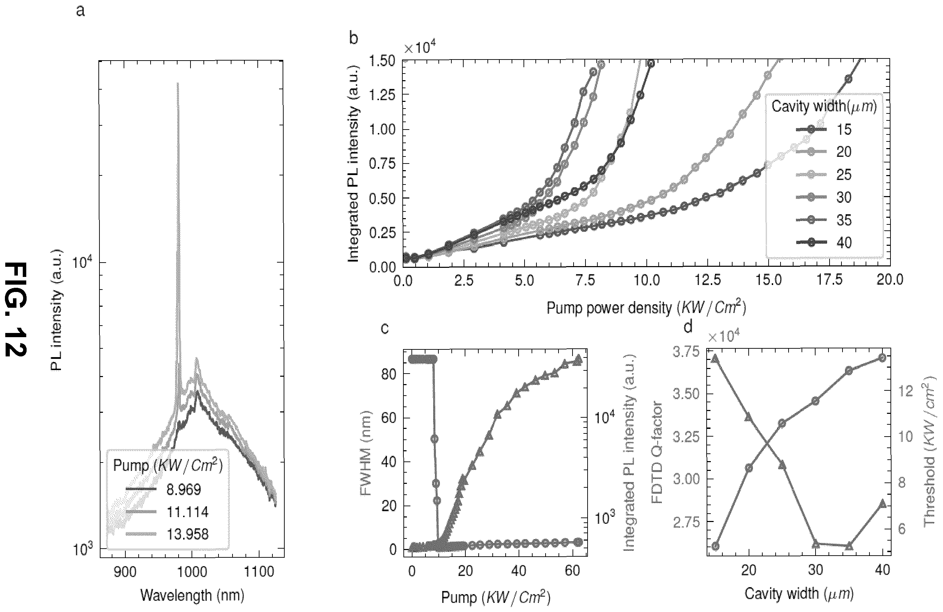

FIG. 12 illustrates room-temperature optical characterization of the device discussed in the example, wherein part (a) shows a lasing spectrum of W_{cavity} = 20 µm NRSEL pixel; part (b) shows an integrated PL for different NRSEL pixels showing the reduction of the threshold with the increase in cavity length, part (c) shows that the line width drops to 0.9 nm above threshold and part (d) shows the measured lasing threshold vs the FDTD calculated Q-factor for different cavity widths of NRSEL pixels.

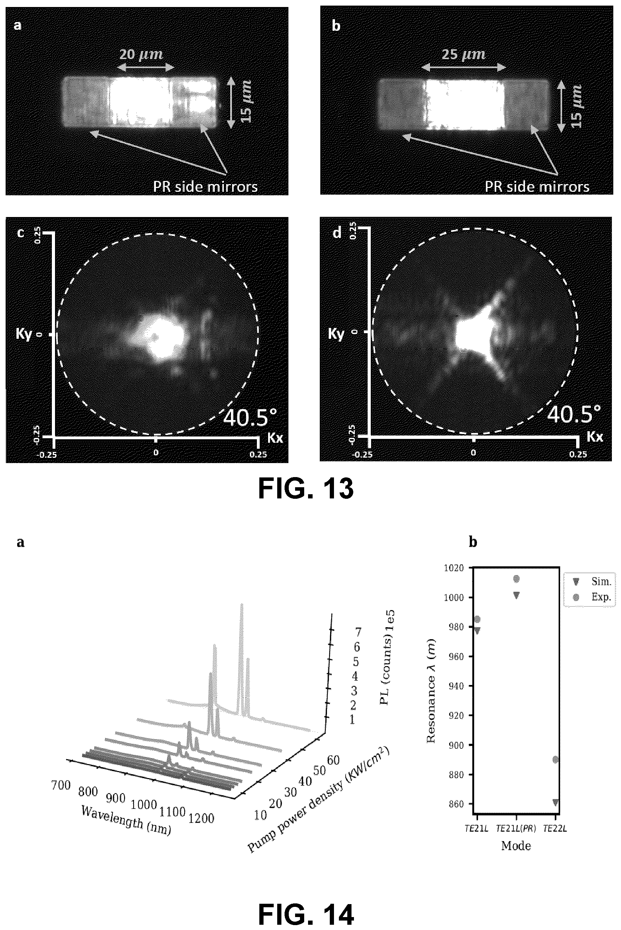

FIG. 13 illustrates, for the embodiment discussed in the example, parts (a) and (c) real space and back focal plane images under optical pumping for a NRSEL of W_{cavity} = 20 µm above lasing threshold. In the real space image, the light is mostly localized inside the cavity but an emission can be seen from the PR mirror region on the right too. In the focal plane image, the light is mostly localized at the Γ point, Kₓ/K₀ = K_{y}/k₀ = 0, with a divergence angle of ~ 12°. Parts (b) and (d) show real space and back focal plane images under optical pumping for a NRSEL of W_{cavity} = 25 µm. All of the light is localized in the cavity region, and a clear reflection can be seen at the interface between the cavity and the PR side mirrors.
FIG. 14 shows mode identification using an optically pumped NRSEL pixel of Wcavity = 20 µm. In part (a) one can identify three peaks: the first peak at 890 nm arises from a high order SBM TE_{22L} mode with a relatively lower Q-factor, and the second and the third peaks are from the SBM TE_{21L} mode inside the cavity and inside the mirror region respectively. Part (b) shows the comparison between the experimental peaks and the resonance frequency of TE_{21L} mode extracted using dispersion diagram simulations, showing a good agreement.

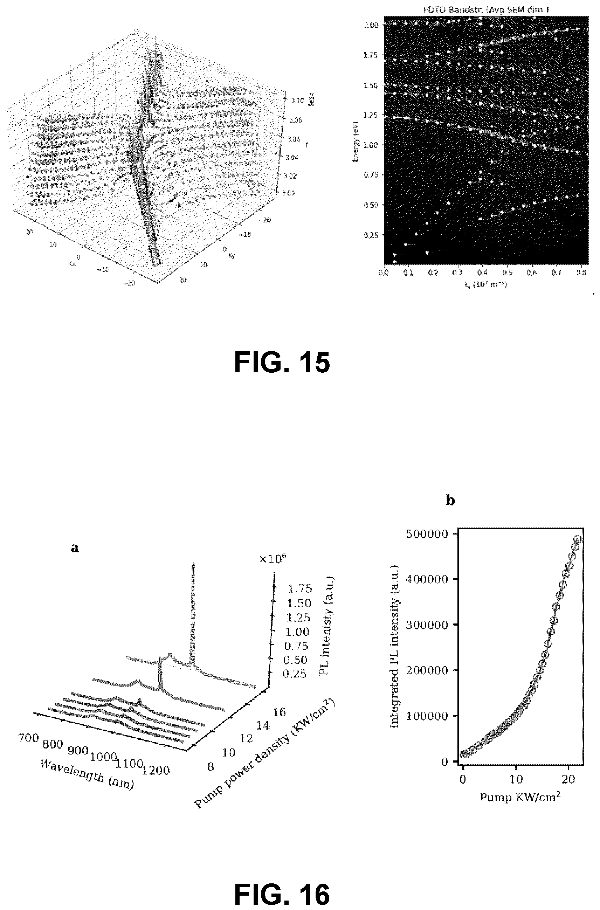

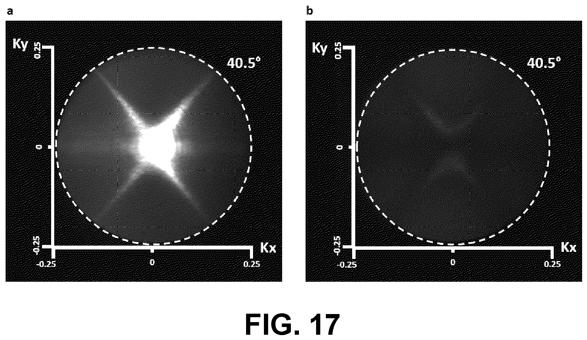

FIG. 15 to 17 show respectively (FIG. 15) a 3D band diagram along Kₓ and K_{y}, (FIG. 16) (a) a lasing spectrum of a quasi-infinite array of period Λ = 380 nm, pumped with a spot size of 300 µm diameter at different pump power densities whereby above the lasing threshold a narrow lasing peak appears at 984 nm and (b) integrated PL intensity showing a lasing threshold around 10 KW/cm², and (FIG. 17) back focal plane images of a quasi-infinite array of period Λ = 380 nm, pumped with a spot size of 300 µm diameter above the lasing threshold for (a) a polarizer aligned along the nano-ridge length and (b) a polarizer perpendicular to the nano-ridge length, whereby the light is mostly polarized parallel to the nano-ridge length as expected from the SBM TE_{21L} mode traversing the nano-ridges, further assisting in the illustration of the example according to an embodiment of the present invention.

In the different figures, the same reference signs refer to the same or analogous elements.

### Detailed description of Illustrative Embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The following terms are provided solely to aid in the understanding of the invention.

As used herein, and unless otherwise specified, the term "surface emitting lasing device" refers to a lasing device that emits light from a surface of the device, such as vertically from a substrate surface or at other angles relative to the substrate surface.

As used herein, and unless otherwise specified, the term "nano-ridge devices" refers to elongated ridge structures with nano-scale dimensions, which are formed on top of a trench, which is defined by the substrate pattern, during epitaxial growth and used to realize a device. The trench width is typically narrower than the nano-ridge width. The width and height of these nano-ridge can vary between 100 nm and a few micrometer (2-5 µm) as a function of the material, trench pattern of the substrate used for growth and target device functionality (e.g., wavelength).

As used herein, and unless otherwise specified, the term "slow light band-edge lasing mode" refers to a lasing mode that is supported by the array of nano-ridge devices and propagates in-plane (parallel with the substrate surface) in a direction non-parallel to a length direction of the nano-ridge devices, such as substantially perpendicular to the length direction of the nano-ridge devices. The slow light band-edge lasing mode is characterized by a reduced group velocity and enhanced light-matter interaction compared to conventional lasing modes. Examples of slow light band-edge lasing modes include modes at the edge of the photonic bandgap in a photonic crystal structure formed by the array of nano-ridge devices.

As used herein, and unless otherwise specified, the term "optical elements" refers to structures or modifications introduced in the array of nano-ridge devices to influence the lasing mode. Optical elements may be formed by varying the properties, configuration, or spacing of the nano-ridge devices or by depositing additional materials between the nano-ridge devices. Examples of optical elements include optical reflectors, mirrors, or cavities formed by inducing periodic variations or depositing reflective materials in subsets of the nano-ridge devices. As used herein, changes in properties or configuration between some nano-ridge devices or in between sub-sets of nano-ridge devices may include one or more of a change of periodicity of nano-ridge devices, a change of dimensions of nano-ridge devices and/or of the spaces in between them, an introduction of material in between nano-ridge- devices locally or along the length of the nano-ridge devices, an introduction of material on top of nano-ridge devices or on top of a sub-set of nano-ridge devices, or a combination of some or all of these.

As used herein, and unless otherwise specified, the term "epitaxially growing" refers to a process of depositing a crystalline layer on a crystalline substrate, where the deposited layer adopts the crystal structure and orientation of the substrate. Epitaxial growth may be performed using techniques such as molecular beam epitaxy (MBE), metal-organic chemical vapor deposition (MOCVD), or liquid phase epitaxy (LPE). Examples of substrates suitable for epitaxial growth of nano-ridge devices include patterned silicon substrates, germanium substrates, III-V semiconductor substrates (e.g., GaAs, InP, InAs, GaSb), or engineered substrates such as SOI, GOI or InPoSi.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a surface emitting lasing device comprising a substrate and an array of parallel nano-ridge devices. The parallel nano-ridge devices are configured for together forming a laser cavity supporting a slow light band-edge lasing mode for lasing across the array of parallel nano-ridge devices and are being configured for coupling out said laser mode from the surface of the substrate to enable surface emission.

Further elements of standard and optional features of corresponding embodiments are discussed with reference to FIG. 1 to FIG. 6, which shows schematic views of examples of a surface emitting lasing device 100 according to embodiments of the present invention. The surface emitting lasing device 100 comprises a patterned substrate 110 and an array 120 of parallel nano-ridge devices 120a, 120b, 120c, etc.. These are epitaxially grown on the patterned substrate 110, e.g., via nano-ridge engineering, which is beneficial if the nano-ridge material has a different lattice constant than the substrate. The parallel nano-ridge devices 120a, 120b, 120c, etc. are configured for together forming a laser cavity supporting the slow light band-edge lasing mode for lasing across the array.

In embodiments, the nano-ridge devices may be composed of III-V, II-VI, or group IV semiconductors. They may be configured to emit light in the 400-4000nm range, e.g. 400-3500nm or 400-2500nm.

This allows for lasing devices with reduced growth time and material consumption compared to VCSELs. The high index contrast in the grating results in good laser operation. Such devices can be used in sensing, spectroscopy, communication or other electronics or photonics applications.

In embodiments, the parallel nano-ridge devices 120a, 120b, 120c, etc. may be arranged in a periodic array. The period of the array may be defined by the substrate pattern and thereby designed for a particular emission wavelength. The emission wavelength can also be tuned by changing the dimensions of the nano-ridges or by depositing additional materials. In embodiments, fine-tuning the laser wavelength may be achieved through different methods such as ALD-layer deposition, ALE, etc. Fine-tuning the laser wavelength may also allow compensation of fabrication tolerances.

In embodiments, the properties, configuration and/or regions between some nano-ridge devices may differ from others in the array of nano-ridge devices 120, inducing optical elements that influence the lasing mode. These optical elements may comprise an optical reflector. In embodiments, adding a back-mirror may enhance light extraction to the front.

In embodiments, additional material may be deposited between sub-sets of nano-ridge devices to induce reflection at boundaries across the array of nano-ridge devices 120. This allows reducing in-plane cavity losses by forming mirrors at the array sides, e.g. by locally shifting the photonic bandgap. Low index materials like silicon oxide can be used. Altering sub-sets at the edges and/or away from the edges enables in-plane confinement of the slow band-edge mode with high Q-factor, lowering the lasing threshold to obtain small devices.

In embodiments, periodicity may be introduced along the nano-ridge length direction through local material deposition in between, above or both, forming a 2D photonic crystal nano-ridge laser.

In embodiments, the substrate 110 may function as a bottom contact with top metal contacts added on the nano-ridge devices for electrical injection. The device can be optically or electrically pumped.

In embodiments, the patterned substrate 110 may provide a crystalline surface for epitaxial growth, e.g. silicon, Ge, engineered substrates like SOI, GOI, InPoSi, III-V substrates like GaAs, InP, InAs, GaSb, or reconstructed substrates may be used. This enables very large-scale integration and high-volume production, as well as integration with other electronics/photonics.

In some embodiments, as shown in FIG. 3, depositing filler material 130, such as e.g. silicon oxide, on the sides or in between of the array 120 of parallel nano-ridge devices may be used for reducing in-plane cavity losses and lowered the lasing threshold. Introducing periodicity along the nano-ridge axis by locally depositing high-index materials 140, 150 transforms the structure into a two-dimensional photonic crystal, as shown in FIG. 4 and FIG. 5. This provides additional design options. Electrical injection is demonstrated using top metal contacts 160 at the sides and using the silicon substrate 110 as a bottom contact, as illustrated in FIG. 6a, which can e.g. be used for small size devices. For larger devices, a pattern of metal plugs can be put at anti-nodes of field which may help in achieving single mode output. By way of illustration, embodiments of the present invention not being limited thereto, some further configurations illustrating examples with contacts for electrical injection are shown in FIG. 6b, FIG. 6c and FIG. 6d. FIG. 6b illustrates an exemplary embodiment wherein top contacts 160 for electrical injection are illustrated for an embodiment according to the present invention. FIG. 6c illustrates an exemplary embodiment wherein electrical top contacts 160 for electrical injection are shown and wherein side mirrors 170 are illustrated, induced by changing the period between the nano-ridge devices of the array 120. The mirrors 170 in this example are passive, but could also be active, i.e. also have electrical contacts. FIG. 6d also illustrates an embodiment with top contacts 160 for electrical injection and with side mirrors 170, whereby the side mirrors 170 are induced by adding an additional layer 180 on subsets of nano-ridge devices of the array 120.

In the second aspect, the invention relates to an integrated circuit comprising at least one surface emitting lasing device 100 according to embodiments of the first aspect. This allows monolithic integration with other photonic or electronic devices. In embodiments, the integrated circuit may comprise multiple surface emitting lasing devices on a common substrate, each configured for a specific laser mode or wavelength. Tuning the emission by the array period, nano-ridge dimensions, or additional materials enables multi-wavelength arrays on the same die/wafer. Changing the material composition allows addressing different wavelength ranges, with multiple growths enabling widely varying wavelengths on the same substrate.

In the third aspect, the invention relates to a method of manufacturing a surface emitting lasing device, the method comprising the steps of
providing a patterned substrate, and
epitaxially growing an array of parallel nano-ridge devices on the substrate, the array being configured to form together a laser cavity supporting a slow light band-edge mode for lasing across the array and coupling out the laser mode from the substrate surface to enable surface emission. The surface emitting lasing devices according to embodiments of the present invention are fabricated using nano-ridge engineering (NRE) techniques which includes aspect ratio trapping (ART) of misfit defects in case the nano-ridge crystal and substrate crystal have different properties. The materials used may include III-V semiconductors grown on a silicon substrate. The array is designed to form a laser cavity supporting a slow light band-edge lasing mode across the nano-ridge devices.

Further by way of illustration, embodiments of the present invention not being limited thereto, an example of a surface emitting laser based on nano-ridges is discussed below. It illustrates standard but also optional features of embodiments of the present invention. In the present example, the active material hence is not grown as a uniform layer as in VCSELs, but in the form of nano-ridges arranged in arrays. These arrays can be considered as a high-index contrast photonic crystal supporting a set of optical modes. A slow light (band-edge) mode can be supported across an array of nano-ridges, forming a standing wave, providing enough feedback for lasing.

By way of illustration, in the present example, the effect of the different design parameters on the device performance are considered. After the nano-ridge epitaxy and the laser fabrication used for the present example is discussed, experimental lasing from an optically pumped nano-ridge surface emitting laser is shown. The devices are further studied using backfocal plane imaging to study the emission pattern and its divergence.

First the design and the simulations are discussed in more detail. The array of nano-ridges can be considered as a high-index contrast one-dimensional photonic crystal, inherently supporting multiple optical modes. The refractive index of the material and the index contrast play a crucial role in determining the photonic band-gap. Additionally, the height of the NR structure determines the number of supported modes. An increase in height results in the emergence of more bands (multi-mode structure), consequently adding complexity to the band diagram. The fill factor and periodicity of the photonic crystal also influence the frequency of the modes. Notably, decreasing the period shifts the bands towards higher frequencies.

To systematically track the optical modes of interest, a structured naming convention was employed. The modes appearing at the band-edge (band-edge modes) are denoted as *TE_{xyz}* and categorized based on the Bragg order (*x*), band number(*y*), and their position relative to the band gap (*z*), indicating whether they are predominantly confined in the dielectric region (lower band (*L*)) or the air region (higher band (*H*)). Focus was put on quasi TE-modes, having their electric field predominantly oriented along the nano-ridges, and hence within the plane of the quantum wells (QW). It is well-known that the compressively strained InGaAs QWs embedded within the GaAs nano-ridges provide the highest gain for this polarisation.

FIG. 8 parts (a), (b) show a schematic representation of the nano-ridge array and the band diagram calculated for an array of nano-ridges with period *P* = 661 nm, height H = 600 nm and width W = 460 nm. The band diagram was calculated using a 2D finite difference time domain (FDTD) simulation with Bloch boundary conditions. The band diagram demonstrates significant mode separation, which arises from the substantial contrast in refractive index between the air and dielectric sections of the photonic crystal. Another result of the high index contrast is the flattening of the bands (reduced dispersion curvature) near the band edges. In FIG. 8 part (c), the mode profiles indicate that the electric field can be predominantly confined either within the dielectric region (*TE*_{21*L*}) or in the air region (*TE*_{21*H*}), depending on their position relative to the band gap.

The modes at the high symmetry Γ point (*kₓ* = 0) are most of interest. At the band-edges, a slow-light Bloch mode (SBM) propagates inside the structure with group velocity *dω*/*dk* approaching zero due to the flat dispersion curvature. This phenomenon can be attributed to the superposition of reflected waves resulting from the index modulation - GaAs and air - at the symmetry points within the structure. The low group velocity allows the photons to have a much longer time of interaction with the active medium, increasing the effective gain and enabling the device to achieve lasing. SBM modes operating close to the Γ point can couple vertically making it possible to realize surface emission. In a perfect and infinite photonic crystal the *TE*_{21*L*} mode cannot couple to radiating modes however, despite being above the light line, due to the asymmetry of the mode's electric field, which has a node in the middle of the nano-ridge, as shown in FIG. 8 part (c). Realistically, the photonic crystal is finite, leading to uncertainty in the in-plane wave vectors and hence, the symmetry doesn't hold up allowing vertical emission.

For optimising the design of the nano-ridges, focus was put on the *TE*_{21*L*} mode, operating at the Γ point, as it provides the highest overlap with the quantum wells in the nano-ridge. As will be shown later, this mode also exhibits the highest Q-factor. Second, the nano-ridge dimensions and the period need to be chosen such that the resonance frequency of this mode matches the QW gain peak, around 1000 nm. FIG. 9 part (a) shows how the resonance frequency of this mode is varying as function of period, fillfactor and height. The fillfactor is defined as nano-ridge width divided by periodicity *FF* = *W*/Λ. The resonance frequency of the band-edge mode is extracted from the band diagram. The simulations were carried out using 2D-FDTD and Bloch boundary conditions. The period of the array obviously has the biggest impact on the resonance frequency. Also the nano-ridge width, and hence the fillfactor have a strong influence. The effect of the nano-ridge height is less important. Given limitations in the mask design (see section: Fabrication), the period of the array was fixed at Λ = 380*nm*. FIG. 9 part (b) shows that, with this period, the emission wavelength can be varied anywhere within the gain bandwidth of the QWs by controlling the nano-ridge height and width.

Whereas above a nano-ridge array with infinite dimensions was considered, although one obtains laser operation of quasi-infinite arrays as illustrated in FIG. 15 to 17, in practice one desires to keep the dimensions more restricted.

Reducing the dimensions of the NRSEL array adversely impacts the device performance however. This is because a reduction in the number of periods results in decreased confinement and in-plane light leakage. This is clearly visible from FIG. 10, which shows a 2D FDTD simulation of the TE_{21*L*} mode for an array of 40 nano-ridges. FIG. 10 part (c) shows how the Q-factor increases with an increasing number of nano-ridge periods, saturating for #nano-ridge larger than 90 periods, when the in-plane losses become negligible. As the Q-factor is inversely proportional to the modal gain threshold *Gₜₕ* = *ω₀*/*Qv_{g}*, reaching a low threshold requires a relatively large device.

This trade-off can be overcome by introducing suitable mirrors at both sides of the cavity. This can be achieved by building a heterostructure from two photonic crystals with shifted bandgap. If one ensures that the frequency of the targeted band-edge mode of the central photonic crystal falls within the bandgap of the surrounding photonic crystal, the latter acts as a mirror and reduces in-plane losses. This approach allows to localize the mode while keeping the Q-factor sufficiently high to ensure low threshold lasing.

The standard approach to shift the bandgap of a photonic crystal is to change its period. However, to ensure a uniform growth process and avoid local variations in the nano-ridge dimensions due to changing loading effects in select area growth also a different approach can be chosen. Also depositing a material with refractive index higher than air, such as SiO₂, between the nano-ridges shifts the bandgap frequency downwards, as illustrated in FIG. 10 part (a). Simulations show that embedding an array of nano-ridges with Λ = 380 nm, H = 410 nm and W = 197 nm within a 1.5 *µm* thick SiO₂ layer with refractive index 1.5, shifts the frequency of the *TE*_{21*L*} mode from 977.2 nm to 1001.3 nm.

FIG. 10 part (d) shows the simulated mode profile for a cavity formed by a central array of 40 uncovered nano-ridges and mirrors of 15 nano-ridges embedded within SiOz. The reduced lateral leakage, increased confinement and reflection at the boundaries is clearly visible. Adding the mirror increases the Q-factor from 15000 to 26053 for the 40 periods device. The vertical emission increases to 20.7% compared to around 14.3% without the side oxide mirrors. Adding a bottom mirror could further increase the vertically coupled power. Note that the upwards radiating field shows a node in the center, originating from the asymmetry of the *TE*_{21*L*} mode mentioned above. In principle this can be avoided using earlier reported strategies.

Integrating GaAs on silicon involves an epitaxy approach utilizing ART to suppress threading dislocations within narrow trenches defined in a SiO₂ layer and NRE to control the shape of the nano-ridges extending above the SiO₂ layer. Despite the significant lattice mismatch between GaAs and silicon, the process produces high-quality GaAs nano-ridges. The details of the growth process are shortly summarized here. Metal-organic vapor phase epitaxy (MOVPE) is employed for GaAs epitaxy based on select area growth, forming the III-V nano-ridge via carefully controlled growth conditions. Standard shallow trench isolation (STI) process is used to from a SiOztrench pattern on a 300 mm (001) silicon substrate. A wet-etch treatment is applied to create V-shaped grooves exposing {111} Si facets between the oxide layer to prevent antiphase-domain formation. Threading dislocations and planar defects are efficiently trapped within high-aspect-ratio trenches of the *SiO*₂ layer. The *SiO*₂ walls traps the misfit and threading dislocations and prevent their propagation outside the trench.

By controlling the MOVPE growth conditions such as the precursor partial pressure in the chamber, substrate temperature, chamber pressure and III-V growth rates the GaAs is grown out of the trenches increasing the material volume and giving the nano-ridge its distinctive shape. Next to GaAs additional III-V layers such as InGaAs and InGaP are deposited on top of the GaAs nano-ridge to realize a III-V heterostructure as an active device structure.

The nano-ridges of the present example are grown in blocks of 5mm × 5mm within which the trench size and period is held constant, ensuring good uniformity, as illustrated in FIG. 7. To define localized NRSEL devices, further processing is required.

Localized nano-ridge surface-emitting lasers (NRSELs) with controlled dimensions are made in the present example. To simplify the process and as a proof-of-principle, we used photoresist instead of SiO₂ to form the mirrors. The photoresist used (AZ 5214) has a similar refractive index (n = 1.5) and can easily be patterned using a standard optical lithography. First arrays of NRSEL devices with different dimensions *W_{NRSEL}* and H*_{NRSEL}* were defined in a AZ5214 photoresist layer using optical lithography. Subsequently the nano-ridge material outside the patterned NRSELs was etched away using a SiCl₄/N₂-based Inductively Coupled Plasma Etching (ICP RIE) process. FIG. 11 part (b) is a cross section SEM image showing the removal of the GaAs nano-ridge material and the InGaAs quantum wells. In FIG. 11 part (c) the NRSEL devices are defined after etching with intact nano-ridges.

In a following step, the mirrors were defined by spin coating photoresist (AZ 5214), which was then patterned through optical lithography. FIG. 11 part (c) shows a cross-section of the mirror section, illustrating the photoresists provides a good filling between the nano-ridges. FIG. 11 part (d) is a microscope picture of the NRSEL array, showing how both W*_{NRSEL}* and H*_{NRSEL}* were varied, allowing us to study the effect of the different design parameters on the operation characteristics. The side mirrors width is kept constant at 15 *µ*m, the increase in the W*_{NRSEL}* goes towards the middle cavity width W*_{cavity}*.

The fabricated samples were measured using micro-photoluminescence (*µ*PL) spectroscopy. An 532-nm nanosecond pulsed Nd:YAG laser was used for optical pumping, the laser is focused into a pump spot of 300 *µ*m diameter using a microscope objective of NA = 0.65. The emission from the devices was collected through the same microscope objective with the help of a dichroic mirror, and detected with a spectrometer (KYMERA-328I-D2-SIL, Oxford instruments, Andor) and a water-cooled InGaAs detector (iDus, DU490A-1.7 Model, Oxford Instruments, Andor) at room temperature.

First, a NRSEL device of cavity width = 20 *µm* was optically pumped to measure the PL emission, the threshold pump density, and the linewidth, FIG. 12 parts (a) and (c). A group of six NRSEL devices were then measured to explore the effect of the cavity width on the lasing threshold and is compared to the Q-factor FDTD simulations, FIG. 12 parts (b) and (d). Two devices were further investigated using back focal plane (BFP) imaging as known as fourier plane imaging, illustrated in FIG. 13.

Upon optical excitation of a NRSEL with W*_{cavity}* = 20 *µm*, the spectra show broad spontaneous emission below lasing threshold as shown in FIG. 12 part (a). With the increase in pump power the background spontaneous emisson slightly blue shifts due to band filling effects. Above the lasing threshold a lasing peak emerges (*λ* = 984 nm). FIG. 12 part (c), shows a reduction in linewidth upon approaching the threshold pump power, ultimately achieving a FWHM of 0.9 *nm.* The lasing threshold is calculated by integrating the PL intensity around the lasing peak, shown in FIG. 12 part (b), then taking the intersection point between the fit of the integrated PL linear region and the pump power (x-axis).

A localized light emission in the mirror region can be also seen for the W*_{cavity}* = 20 *µm* NRSEL as shown in FIG.13 part (a). Light emission is not expected from the mirror region, since the SBM *TE*_{21*L*} mode has a relatively lower Q-factor relative to the cavity's SBM mode and the mirror region is smaller of 15 *µm* width. The variation in the nano-ridge's dimensions and imperfections can lead to the localization of light emission in some parts of the array more than others, especially since it can not be observed consistently in NRSEL devices of W*_{cavity}* = 20 and W*_{cavity}* = 25 *µm,* shown in FIG. 13 parts (a) and (b). The microscope images also show clear reflection at the cavity boundaries due to the PR mirrors for both devices, indicating a success in the light confinement in the cavity.

To evaluate the effect of the cavity width on the devices' lasing threshold, we optically pumped a series of devices with W*_{cavity}* varying from 15 and 40 *µm.* FIG. 12 part (b) shows the associated light-in vs. light-out curves and FIG. 12 part (d) shows how the threshold pumping density varies with the cavity width.

In FIG. 12 part (d), one can see a clear dependence of the cavity width on the lasing threshold as predicted by the theory and FDTD simulations of FIG. 12 part (a). The lasing threshold went down to approximately 5 *kW*/*cm²* for a W*_{cavity}* of 35 *µm.* The lasing threshold decreases with the increase in the W*_{cavity}* reaching a minimum before increasing again. This could be another indication of the random disorder effects. Longer cavity photonic crystal lasers are susceptible to higher losses associated with such disorder resulting from working closer to the band-edge (slow-light induced losses).

The devices were studied further using backfocal plane imaging also known as fourier imaging.

FIG. 13, shows the backfocal plane image of two NRSELs of different cavity dimensions above their respective lasing threshold. The back focal plane (BFP) of an objective lens contains information about the emission wavevectors (momentum) from the sample plane. By imaging the BFP, the angular distribution of light emitted from the photonic crystal can be mapped to momentum space using the formula: *K_{∥}* = *sin*(*θ*) × *K*₀. The inplane k-vector (*K_{∥}*) can be evaluated knowing the emission wavelength (*K*₀ = 2*π*/*λ* and the emission angle (*θ*). This mapping is crucial for understanding the dispersion relations in photonic crystals. The backfocal plane images for both devices show an angle of divergence lower than 12° of the nano-ridge's photonic crystal one dimensionality, it displays a unique emission pattern in which modes are restricted to specific directions. This emission pattern effectively represents the equifrequency contour for the nano-ridge photonic crystal's band (see supplementary information). The isofrequency contour is more pronounced for the bigger cavity width, it corresponds to the SBM mode *TE*_{21*L*} as it will be further shown. The images show a high light intensity localization, corresponding to the low group velocity Γ point. Additionally, the backfocal plane images show variations and imperfections in the emission pattern with localized high intensities FIG. 13 part (c) or even favored propagation direction FIG. 13 part (d). This can also be attributed to the localized modes due to the disorder in the photonic crystal. Further investigation of this phenomenon is needed to further verify the effect of disorder and fabrication variations on the behavior of the devices. A high degree of polarization, along the nano-ridge length, can be seen for the nano-ridge arrays above the lasing threshold. The SBM mode is expected to be traveling across the nano-ridges with low group velocity with the same polarization, confirming our theory that the SBM mode is responsible for the lasing behaviour (see supplementary information of FIG. 15 to 17).

To further identify the lasing SBM mode, A NRSEL pixel of W*_{cavity}* = 20 *µm* was optically pumped and measured using the CMOS sensor to be able to measure wavelengths shorter than 900 nm, as shown in FIG. 14. This device shows emission from both the mirror regions and the cavity region, shown in FIG. 13 part (a). With the increase in pump power, a peak shows at 985 nm first, then another one at 1010 nm, lastly a third one around 890 nm.

Comparing the results to the band diagram simulations of FIG. 14, the first peak (985 nm) matches the *TE*_{21*L*} of Q-factor 26053 (for a cavity size of 40 nano-ridges). The second peak (1010 nm) represents the emission from the mirror region and it matches *TE*_{21*L*} for a nano-ridge array with Photoresist. given the mode's lower Q-factor it shows up at higher pump powers. The third peak (890 nm) matches the higher order *TE*₂₂*_{L}.* This mode has a relatively lower Q-factor of 4056 and overlap with the quantum wells compared to *TE*_{21*L*}, additionally it lies beyond the gain of the InGaAs quantum wells in the GaAs gain region. Explaining the significantly high threshold pump power.

The average SEM dimensions across the wafer and an estimation of the effective indices of the materials were used for the FDTD simulations which can explain the difference between the absolute peak position for the experiment and the simulations.

The present example illustrates novel optically pumped epitaxially grown surface emitting nano-ridge lasing (NRSEL) on a 300-mm silicon wafer. It illustrates that stimulated emission and low threshold lasing (5 kW/Cm²) for a short cavity (20 *µ*m) can be obtained. Also, the far-field pattern illustrates the possibility for electrically injected NRSEL devices. NRSEL devices grown directly on silicon along with other photonic/electronic components offer a huge potential for fully integrated applications on one chip, e.g. sensing, LIDARs and communication.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used.

## Claims

1. A surface emitting lasing device (100) comprising:
- a substrate (110); and
- an array (120) of parallel nano-ridge devices (120a, 120b, 120c, ...) epitaxially grown on the substrate (110),
the parallel nano-ridge devices (120a, 120b, 120c, ...) being configured for together forming a laser cavity supporting a slow light band-edge lasing mode for lasing across the array of parallel nano-ridge devices (120a, 120b, 120c, ...) and being configured for coupling out said laser mode from a surface of the substrate (110) to enable surface emission.

2. The surface emitting lasing device (100) according to claim 1, wherein the parallel nano-ridge devices (120a, 120b, 120c, ...) are arranged in a periodic array.

3. The surface emitting lasing device (100) according to any of the previous claims, wherein the properties of some of the nano-ridge devices, the configuration of some of the nano-ridge devices and/or the properties of regions in between some of the nano-ridge devices are different from other nano-ridge devices or regions in between other nano-ridge devices in the array, thereby inducing one or more optical elements in the surface emitting lasing device (100) optically influencing the lasing mode.

4. The surface emitting lasing device (100) according to claim 3, wherein the one or more optical elements comprise an optical reflector.

5. The surface emitting lasing device (100) according to any one of the previous claims, wherein an additional material is deposited between the nano-ridge devices for sub-sets of parallel nano-ridge devices for inducing reflection at one or more boundaries across the array of parallel nano-ridge devices (120a, 120b, 120c, ...).

6. The surface emitting lasing device (100) according to any of the previous claims, wherein along a length direction of the nano-ridge devices (120a, 120b, 120c, ...) a periodicity is introduced through local deposition of material in between, above or combined in between and above the parallel nano-ridge devices.

7. The surface emitting lasing device (100) according to any of the previous claims, wherein the substrate (110) functions as a bottom contact and wherein the device (100) furthermore comprises top metal contacts for electrical injection.

8. The surface emitting lasing device (100) according to any of the previous claims, wherein the substrate (110) is a substrate providing a crystalline surface for epitaxial growth.

9. The surface emitting lasing device (100) according to any one of the preceding claims, wherein the nano-ridge devices (120a, 120b, 120c, ...) are composed of a material selected from the group consisting of III-V semiconductors, II-VI semiconductors, and group IV semiconductors.

10. The surface emitting lasing device according to any one of the preceding claims, wherein the nano-ridge devices (120a, 120b, 120c, ...) are configured to emit light in the wavelength range of 400 nm to 4000 nm.

11. An integrated circuit comprising at least one surface emitting lasing device (100) according to any of claims 1 to 10.

12. The integrated circuit according to claim 11, the integrated circuit comprising a plurality of surface emitting lasing devices (100) according to any of claims 1 to 10 implemented on a common substrate (110), each surface emitting lasing device (100) being configured for inducing a specific laser mode or specific wavelength.

13. The integrated circuit according to any of claims 11 to 12, wherein the integrated circuit is a photonic circuit or an electronic circuit.

14. A method of manufacturing a surface emitting lasing device (100), the method comprising:
- providing a substrate (110);
- epitaxially growing an array of parallel nano-ridge devices (120a, 120b, 120c, ...) on the substrate (110), the array of parallel nano-ridge devices being configured to form together a laser cavity supporting a slow light band-edge lasing mode for lasing across the array of parallel nano-ridge devices, and to couple out the laser mode from the surface of the substrate to enable surface emission.

15. A method of using a surface emitting lasing device (100) according to any of claim 1 to 10 for inducing a laser beam, for sensing, for spectroscopy, for communication or for other electronics or photonics applications.
